# EUROPÄISCHE PATENTSCHRIFT

(11) **EP 2 772 676 B1**
(45) Veröffentlichungstag und Bekanntmachung des Hinweises auf die Patenterteilung: **08.07.2015**
(21) Anmeldenummer: 11166555.0
(22) Anmeldetag: 18.05.2011
(51) Int. Cl.: H01S 5/42, H04N 13/02

(54) **3D-Kamera und Verfahren zur dreidimensionalen Überwachung eines Überwachungsbereichs**
3D camera and method for three dimensional surveillance of a surveillance area
Caméra 3D et procédé de surveillance tridimensionnel d'un domaine de surveillance

(43) Veröffentlichungstag der Anmeldung: 03.09.2014
(73) Patentinhaber: SICK AG, 79183 Waldkirch (DE)
(72) Erfinder: Schneider, Florian, Dr., 79276 Reute (DE); Schmitz, Stephan, Dr., 79108 Freiburg (DE)
(74) Vertreter: Ludewigt, Christoph

(56) Entgegenhaltungen:
- EP-A1- 2 019 281
- WO-A1-2006/085834
- WO-A1-2006/109308
- CN-A- 1 809 867
- US-A1- 2004 184 031
- US-A1- 2004 247 236
- US-A1- 2007 025 612
- US-A1- 2009 225 329
- US-A1- 2010 008 588
- US-A1- 2010 073 461
- US-A1- 2010 118 123

## Beschreibung

Die Erfindung betrifft eine 3D-Kamera mit einer Beleuchtungseinheit und ein Verfahren zur dreidimensionalen Überwachung eines Überwachungsbereichs nach dem Oberbegriff von Anspruch 1 beziehungsweise 15.

Im Gegensatz zu einer herkömmlichen Kamera nimmt eine 3D-Kamera auch eine Tiefeninformation auf und erzeugt somit dreidimensionale Bilddaten, die auch als Entfernungsbild oder Tiefenkarte bezeichnet werden. Die zusätzliche Entfernungsdimension lässt sich in einer Vielzahl von Anwendungen nutzen, um mehr Informationen über Objekte in der von der Kamera erfassten Szenerie zu gewinnen.

Ein Beispiel dafür ist die Sicherheitstechnik. Eine typische sicherheitstechnische Anwendung ist die Absicherung einer gefährlichen Maschine, wie etwa einer Presse oder eines Roboters, wo bei Eingriff eines Körperteils in einen Gefahrenbereich um die Maschine herum eine Absicherung erfolgt. Dies kann je nach Situation die Abschaltung der Maschine oder das Verbringen in eine sichere Position sein. Mit der zusätzlichen Tiefeninformation lassen sich dreidimensionale Schutzbereiche definieren, die genauer an die Gefahrensituation anpassbar sind als zweidimensionale Schutzfelder, und es kann auch besser beurteilt werden, ob sich eine Person in kritischer Weise an die Gefahrenquelle annähert.

In einer weiteren Anwendung werden erfasste Bewegungen als Befehl an eine mit der 3D-Kamera verbundene Steuerung interpretiert. Dazu werden beispielsweise Gesten erfasst. Obwohl dies in erster Linie aus der Unterhaltungselektronik bekannt ist, kann es auch genutzt werden, um einen Sensor in der Sicherheitstechnik zu bedienen oder zu konfigurieren, wie etwa in der DE 10 2010 017 857 beschrieben.

Ein bekanntes Prinzip zur Erfassung dreidimensionaler Bilddaten beruht auf Triangulation unter Zuhilfenahme einer aktiven Musterbeleuchtung. Bei stereoskopischen Systemen werden dann jeweils mindestens zwei Aufnahmen aus unterschiedlicher Perspektive erzeugt. In den überlappenden Bildbereichen werden gleiche Strukturen identifiziert und aus der Disparität und den optischen Parametern des Kamerasystems mittels Triangulation Entfernungen und somit das dreidimensionale Bild beziehungweise die Tiefenkarte berechnet.

Eine Stereokamera ist prinzipiell auch in der Lage, passiv zu arbeiten, d.h. ohne eine eigene Musterbeleuchtung. Für eine zuverlässige Bildauswertung, ganz besonders im Rahmen der Sicherheitstechnik, besteht aber der Anspruch, die dreidimensionalen Bilddaten in Form einer dichten Tiefenkarte zu erzeugen, also einen zuverlässigen Abstandswert für jeden auszuwertenden Bildbereich und bevorzugt nahezu jeden Bildpunkt verfügbar zu haben. Ist die zu überwachende Szenerie kontrastschwach oder weist Bereiche mit wenig Struktur auf, so wird dies mit einem passiven Sensor nicht erreicht. Große strukturlose Flächen oder zueinander ähnliche Strukturmerkmale können eine eindeutige Zuordnung von Bildbereichen beim Auffinden der Korresponden- , zen zwischen den Strukturelementen der Bilder verhindern. Die Folge sind Lücken in den dreidimensionalen Bildern oder fehlerhafte Berechnungen der Entfernungen.

Andere Triangulationssysteme verwenden nur eine Kamera und werten die Veränderungen des projizierten Musters durch Objekte in verschiedenen Entfernungen aus. Dazu wird dem System das Beleuchtungsmuster eingelernt und so eine Erwartung haltung für die Bilddaten bei verschiedenen Objektentfernungen und -strukturen generiert. Eine Möglichkeit besteht darin, das Beleuchtungsmuster auf Objekten, insbesohdere einer Fläche, in verschiedenen Entfernungen als Referenzbild einzulernen. In einem derartigen System ist eine aktive Beleuchtung von vorne herein unverzichtbar.

Aus der EP 2 166 304 A1 ist eine Beleuchtungseinheit für eine stereoskopische Sicherheitskamera bekannt. Dabei wird ein selbstunähnliches Beleuchtungsmuster mit Hilfe eines optischen Phasenelements erzeugt, das von einer divergenten Laserlichtquelle durchstrahlt wird. Mit einem solchen Phasenelement sind die notwendigen Intensitäten des Beleuchtungsmusters in einer gewünschten Reichweite nicht zu erzielen.

In der US 2007/0263903 A1 erzeugt ein stereoskopisches Kamerasystem mittels einer Beleuchtungseinheit ein strukturiertes Beleuchtungsmuster, welches dann verwendet wird, um Entfernungen zu berechnen. Dabei entsteht das Muster, indem ein diffraktives optisches Element mit einem Laser oder einer LED beleuchtet wird. Problematisch bei der Verwendung eines diffraktiven optischen Elements ist, dass ein relativ großer Lichtanteil in nullter Beugungsordnung transmittiert wird. Aus Gründen der Augensicherheit kann deshalb diese Beleuchtungseinheit nicht mit den erforderlichen Lichtstärken betrieben werden.

In der WO 2009/093228 A2 wird deshalb in einer ähnlichen Anordnung ein zweites diffraktives optisches Element nachgeordnet. Der Lichtstrahl nullter Beugungsordnung wird auf diese Weise nochmals verteilt.

Die Verwendung von Beleuchtungseinheiten auf Basis diffraktiver optischer Elemente hat aber den weiteren Nachteil, dass die dafür als Leuchtmittel erforderlichen Singlemode-Laserdioden mit sehr kleiner Emitterfläche nur mit relativ geringer Ausgangsleistung deutlich unterhalb einem Watt verfügbar sind und nur eine begrenzte Lebensdauer haben. Dies wirkt sich nachteilig auf den Sichtbereich oder Bildfeldwinkel, die Reichweite, die Belichtungszeit und die Detektiorisfähigkeit beziehungsweise Verb barkeit aus. Damit sind derartige Beleuchtungseinheiten gerade zur Beleuchtung gröβerer Bereiche in größeren Entfernungen, wie sie bei Anwendungen in der Sicherheitstechnik erforderlich sind, nur eingeschränkt verwendbar.

In einem anderen bekannten Ansatz, der beispielsweise in der US 2008/0240502 A1 beschrieben wird, erzeugt ein Dia ein Punktmuster für einen 3D-Sensor. Gemäß US 2010/0118123 A1 weist dieses Dia eine Vielzahl unregelmäßig angeordneter Mikrolinsen auf.

Die Verwendung eines Projektionsverfahrens mit einem Dia beziehungsweise einem Dia mit Mikrolinsen ist aber energetisch und damit ökonomisch nur begrenzt effizient. Bei der Verwendung eines herkömmlichen Dias werden die dunklen Bereiche des Beleuchtungsmusters hart abgeschattet und nicht energieeffizient umverteilt, so dass das abgeschattete Licht nur zur Erwärmung und nicht zur Ausleuchtung des Überwachungsbereichs beträgt. Je geringer der Füllgrad des Musters ist, also das Verhältnis von Transmissions- zu Gesamtfläche des Dias, desto geringer auch der Wirkungsgrad. Das wirkt sich deshalb besonders nachteilig aus, weil bereits ein Füllgrad von beispielsweise 10-20% für die Erfassung dichter Tiefenkarten ausreicht. Damit bleiben 80-90% der Ausgangsleistung ungenutzt. Dies ist nicht nur energetisch ineffizient, sondern treibt auch die Herstellungskosten in die Höhe, weil der Preis von Laserdioden in etwa linear mit der optischen Ausgangsleistung skaliert.

Der Einsatz von Dias mit Mikrolinsen erhöht aufgrund der Umverteilung des Lichts die Effizienz im Vergleich zu einem herkömmlichen Dia. Aufgrund der angestrebten Struktur des Beleuchtungsmusters und damit der Verteilung der Mikrolinsen gibt es aber auch hier ungenutzte Teilbereiche, und eine gute Effizienz lässt sich daher nur bis zu einem gewissen Grad erreichen.

Aus der EP 2 019 281 A1, die den nächsten Stand der Technik bildet, ist ein 3D-Sensor bekannt, der eine Beleuchtungseinheit aufweist, um ein zweidimensionales Beleuchtungsmuster zu erzeugen, das zumindest in Teilbereichen inhomogen, aperiodisch beziehungsweise selbstunähnlich ist. Dabei kann als Lichtquelle eine LED oder ein LED-Array vorgesehen sein. Das Beleuchtungsmuster entsteht dann durch eine Maske in Form eines Dias, einer geätzten Folie oder eines beschichteten oder bedruckten Trägermaterials. Alternativ ist eine Laserlichtquelle oder ein Laserdiodenarray mit einem diffraktiven optischen Element vorgesehen.

Die WO 2006/109308A1 beschreibt ein Echtzeit-Bildaufnahmesystem mit strukturiertem Licht. Die Beleuchtung erfolgt über ein steuerbares Spiegelarray, ein Mustererzeugungselement (SLM) oder ein steuerbares LED- bzw. Laserarray.

Es ist daher Aufgabe der Erfindung, eine effizientere Erzeugung eines Beleuchtungsmusters für eine 3D-Kamera zu ermöglichen.

Diese Aufgabe wird durch eine 3D-Kamera mit mindestens einer Beleuchtungseinheit und ein Verfahren zur dreidimensionalen Überwachung eines Überwachungsbereichs nach Anspruch 1 beziehungsweise 15 gelöst. Dabei geht die Erfindung von dem Grundgedanken aus, das gewünschte Muster direkt mit der Lichtquelle zu erzeugen. Das ermöglicht den Verzicht auf ein nachgeordnetes Musterelement und damit eine optimale Lichtausbeute. Dazu wird anstelle einer einzelnen homogenen Lichtquelle ein Halbleiterarray mit einer Vielzahl von Einzelemitterelementen eingesetzt, die unregelmäßig angeordnet werden. Jedes Einzelemitterelement erzeugt einen Einzellichtstrahl, der beim Auftreffen auf ein Objekt in der Szenerie ein Musterelement bildet.

Die unregelmäßige Struktur des Beleuchtungsmusters wird demnach direkt durch die unregelmäßige Anordnung der Einzelemitterelemente erreicht. Dabei wird unter einer unregelmäßigen Anordnung eine solche verstanden, die keine oder zumindest möglichst wenige Scheinkorrelationen bei der Bildauswertung verursacht. Im Idealfall ist die Anordnung und damit das Beleuchtungsmuster selbstunähnlich, kann also nicht durch einfache Symmetrieoperationen wie Translationen oder Drehungen in sich selbst überführt werden. Bei Stereokameras sind hier in erster Linie Translationen parallel zum Horizont relevant.

Die Erfindung hat den Vorteil, dass Beleuchtungsmuster mit besonders hoher optischer Ausgangsleistung bei hoher Effizienz erzeugt werden können. Das für die jeweilige Anwendung geeignete Beleuchtungsmuster ist dabei durch die Struktur des Halbleiterarrays und die Anordnung der Einzelemitterelemente anpassbar. Damit wird der Einsatzbereich von 3D-Kameras, insbesondere von kamerabasierten Triangulationssensoren erweitert. Sichtbereich, Bildfeldwinkel, Reichweite, Detektionsfähigkeit und Verfügbarkeit werden erhöht und die Beleuchtungszeit verringert.

Das Halbleiterarray ist bevorzugt ein VCSEL-Array (Vertical-Cavity Surface-Emitting Laser). Durch eine unregelmäßige Maske für die Emitterflächen wird die gewünschte Anordnung der Einzelemitterelemente des VCSEL-Arrays erreicht. Da aufgrund der erfindungsgemäßen Anordnung von der ursprünglichen Ausgangsleistung kaum etwas verloren geht, genügen VCSEL-Arrays mit moderaten Gesamtleistungen von einigen Watt, wobei natürlich auch VSCEL-Arrays mit höheren Leistungen insbesondere für sehr große Reichweiten eingesetzt werden können.

Das Halbleiterarray weist bevorzugt eine große Anzahl von mindestens tausend, zehntausend oder hunderttausend Einzelemitterelementen auf. Solche Halbleiterarrays sind beispielsweise in Form von VCSEL-Arrays vergleichsweise kostengünstig erhältlich. Die große Anzahl an Einzelemitterelementen mit einer entsprechend hohen Anzahl von Musterelementen in dem Beleuchtungsmuster führt zu einem Beleuchtungsmuster mit hinreichend feiner Struktur, um eine hohe Auflösung der 3D-Kamera zu gewährleisten.

Jedes Einzelemitterelement weist bevorzugt eine punktförmige Abstrahlfläche auf, wobei das von dem Einzelemitterelement erzeugte Musterelement die Form der Abstrahlfläche aufweist. Damit entsteht ein Punktmuster, bei dem jedes Musterelement ein von einem Einzelemitterelement erzeugter Punkt ist, wobei dies natürlich nicht im strengen geometrischen Sinne als dimensionslos zu verstehen ist. Der Punkt hat eine gewisse endliche Ausdehnung und soll dies auch haben, um von dem Bildsensor erfasst zu werden. Auch hat der Punkt eine geometrische Form, ist beispielsweise kreis- oder ellipsenförmig, rechteckig oder allgemein durch ein Polygon begrenzt.

Die punktförmigen Abstrahlflächen weisen bevorzugt untereinander unterschiedliche Formen und/oder Größen auf. Die Abstände der Abstrahlflächen untereinander sind aufgrund der unregelmäßigen Anordnung ohnehin schon verschieden. Werden außerdem noch die Formen beziehungsweise Größen variiert, so entsteht ein noch unregelmäßigeres Beleuchtungsmuster. Dies hängt auch vom Auswertungsalgorithmus ab. Eine gewisse Mindestgröße der Musterelemente ist erforderlich, andererseits erhöht ein zu großes Musterelement lediglich den Füllfaktor und damit letztlich den Energiebedarf, ohne die Erkennungsleistung zu verbessern. Alternativ ist auch zur vereinfachten Herstellung denkbar, dass alle punktförmigen Abstrahlflächen untereinander die gleiche Größe und Geometrie aufweisen. Die Unregelmäßigkeit des Beleuchtungsmusters beruht dann allein auf den unterschiedlichen Abständen. Dies bietet aber genügend Freiheitsgrade, um Scheinkorrelationen zu unterdrücken.

Die Einzelemitterelemente bilden bevorzugt mindestens zwei Gruppen, wobei eine Gruppe von Einzelemitterelementen aktivierbar ist, ohne die übrigen Gruppen von Einzelemitterelementen zu aktivieren. Damit kann zwischen verschiedenen Mustern umgeschaltet werden, die durch jeweils eine Gruppe oder eine Kombination mehrerer Gruppen entstehen. Im Grenzfall bildet jedes Einzelemitterelement eine eigene Gruppe und ist damit selektiv aktivierbar. Bildet man das Halbleiterarray mit einer höheren Packungsdichte von Einzelemitterelementen aus, als für die Beleuchtung erforderlich ist, so bewirkt auch die Aktivierung von Teilmengen eine ausreichende Beleuchtung. Durch gezielte Auswahl solcher Teilmengen oder Gruppenkombinationen wird dann eine adaptive Anpassung des Beleuchtungsmusters an die gegebene Szenerie ermöglicht.

Die Einzelemitterelemente sind bevorzugt mit untereinander unterschiedlichen Strömen ansteuerbar. Das lässt sich beispielsweise durch unterschiedliche Widerstände beziehungsweise Dicken der Zuleitungen erreichen. Die einzelnen Musterelemente werden durch den derart eingeführten Leistungsgradienten unterschiedlich hell. Auch das kann zur Adaption an eine Szenerie ausgenutzt werden. Ein Fall von allgemeinerem Interesse ist die Kompensation des Randabfalls. Das ist ein nachteiliger Effekt von Optiken beziehungsweise Bildsensoren, die zu ungleichmäßig beleuchteten Bildern mit dunkleren Rändern führen. Dies wird ausgeglichen, indem vorzugsweise die Einzelemitterelemente in einem Außenbereich des Halbleiterarrays mit höheren Strömen ansteuerbar sind als Einzelemitterelemente in einem Innenbereich des Halbleiterarrays.

Die Dichte der Einzelemitterelemente auf dem Halbleiterarray ist bevorzugt unterschiedlich. Das ist eine alternative oder kumulative Möglichkeit, hellere und dunklere Bereiche in dem Beleuchtungsmuster zu erzeugen. Auch das kann insbesondere zur Kompensation des Randabfalls verwendet werden. Dazu sind vorzugsweise in einem Außenbereich des Halbleiterarrays mehr Einzelemitterelemente vorgesehen als in einem Innenbereich des Halbleiterarrays.

Die Anordnung der Musterelemente in dem Beleuchtungsmuster entspricht bevorzugt der Anordnung der Einzelemitterelemente auf dem Halbleiterarray. Die Struktur des Beleuchtungsmusters ist damit direkt durch die Anordnung der Einzelemitter auf dem Halbleiterarray vorgegeben. Es gibt dabei keine nachgeschalteten Musterelemente wie einleitend beschrieben, die das Beleuchtungsmuster erzeugen oder verändern.

Die Beleuchtungseinheit weist bevorzugt ein Abbildungsobjektiv auf, um das Beleuchtungsmuster aus dem Nahfeld bei dem Halbleiterarray in den Überwachungsbereich abzubilden. Als Abbildungsobjektiv genügt im einfachsten Fall eine einzige Linse. Das Abbildungsobjektiv kann aber auch reflexiv statt refraktiv ausgebildet sein.

Die Einzelemitterelemente müssen dank des Abbildungsobjektivs das Musterelement nicht im Fernfeld des Überwachungsbereichs erzeugen, sondern das Muster wird schon kurz hinter dem Mustererzeugungselement abgegriffen und in den Überwachungsbereich projiziert. Das Abbildungsobjektiv gleicht die Divergenz der Einzelemitterelemente aus, die mit geringerer Abstrahlfläche zunimmt. Alternativ zu einer solchen Abbildung ist auch denkbar, dass die einzelnen Musterelemente von dem Mustererzeugungselement direkt, ohne weitere nachgeordnete optische Elemente in dem Überwachungsbereich erzeugt werden. Dann muss aber die Divergenz der Einzelemitterelemente so gering sein, dass auch ohne Abbildungsobjektiv eine unregelmäßige und keine durchmischte, homogene Beleuchtung entsteht.

Abbildungsobjektiv und Halbleiterarray sind vorzugsweise zueinander verschieblich angeordnet, um unterschiedliche Teilmengen von Einzelemitterelementen abzubilden. Es wird dabei jeweils ein anderer Bereich des Halbleiterarrays ausgenutzt, um das Beleuchtungsmuster zu erzeugen, um so eine Anpassung an die Szenerie zu ermöglichen.

In einer bevorzugten Weiterbildung ist dem Halbleiterarray ein Mikrolinsenarray vorgeordnet. Die einzelnen Mikrolinsen fokussieren jeweils die Einzellichtstrahlen der Einzelemitterelemente. Dadurch können Divergenzen des Halbleiterarrays ausgeglichen oder besonders kleine, scharf abgegrenzte Musterelemente erzeugt werden. Noch bevorzugter bilden die Mikrolinsen auf dem Mikrolinsenarray die gleiche unregelmäßige Anordnung wie die Einzelemitterelemente auf dem Halbleiterarray. Dadurch wird eine optimale Zuordnung von Mikrolinsen und Einzelemitterelementen erreicht. Alternativ ist auch denkbar, dass die Anordnungen von Mikrolinsen und Einzelemitferelementen voneinander abweichen. Das Mikrolinsenarray wird damit selbst musterbildend oder zumindest musterverändernd.

Die 3D-Kamera ist bevorzugt als Stereokamera ausgebildet und weist eine Auswertungseinheit auf, welche für die Anwendung eines Stereoalgorithmus ausgebildet ist, in dem zur Erzeugung eines dreidimensionalen Entfernungsbildes einander zugehörige Teilbereiche der von den beiden Kameras der Stereokamera aufgenommenen Bilder des von dem Beleuchtungsmuster ausgeleuchteten Überwachungsbereichs erkannt und deren Entfernung anhand der Disparität berechnet wird. Der erfindungsgemäß erhöhte Kontrast in der Szenerie hilft dabei, auch bei einer ungünstigen Szenerie dichte Tiefenkarten zu erfassen.

Die 3D-Kamera ist bevorzugt als Sicherheitskamera ausgebildet, wobei die Auswertungseinheit unzulässige Eingriffe in den Überwachungsbereich erkennen und daraufhin ein Abschaltsignal erzeugen kann, und wobei ein Sicherheitsausgang vorgesehen ist, um darüber ein Abschaltsignal an eine überwachte Maschine auszugeben. Gerade für sicherheitstechnische Anwendungen ist eine zuverlässige Erfassung einer dichten Tiefenkarte erforderlich. Dadurch wird die erforderliche sichere Objektdetektion ermöglicht.

Das erfindungsgemäße Verfahren kann auf ähnliche Weise weitergebildet werden und zeigt dabei ähnliche Vorteile. Derartige vorteilhafte Merkmale sind beispielhaft, aber nicht abschließend in den sich an die unabhängigen Ansprüche anschließenden Unteransprüchen beschrieben.

Vorzugsweise werden dabei jeweils zwei Bilder des ausgeleuchteten Überwachungbereichs aus unterschiedlicher Perspektive aufgenommen, und daraus wird mittels eines Stereoalgorithmus' ein dreidimensionales Entfernungsbild berechnet, indem einander zugehörige Teilbereiche der beiden Bilder erkannt und deren Entfernung anhand der Disparität berechnet wird.

Bevorzugt werden in dem Entfernungsbild unzulässige Eingriffe in den Überwachungsbereich erkannt, und daraufhin wird ein Abschaltsignal an eine überwachte gefährliche Maschine ausgegeben.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine schematische Gesamtdarstellung einer Ausführungsform einer erfindungsgemäßen 3D-Kamera mit dem von deren Beleuchtungseinheit ausgeleuchteten Überwachungsbereich;
- Fig. 2: eine schematische Draufsicht auf ein Halbleiterarray mit unregelmäßiger Anordnung von Einzelemitterelementen;
- Fig. 3: eine schematische Seitenansicht einer erfindungsgemäßen Beleuchtungseinheit mit einem Halbleiterarray gemäß Figur 2;
- Fig. 4: eine schematische Seitenansicht einer zu Figur 3 alternativen Beleuchtungseinheit mit einer reflexiven Optik; und
- Fig. 5: eine schematische Draufsicht auf ein weiteres Halbleiterarray mit mehreren selektiv aktivierbaren Gruppen von Einzelemitterelementen.

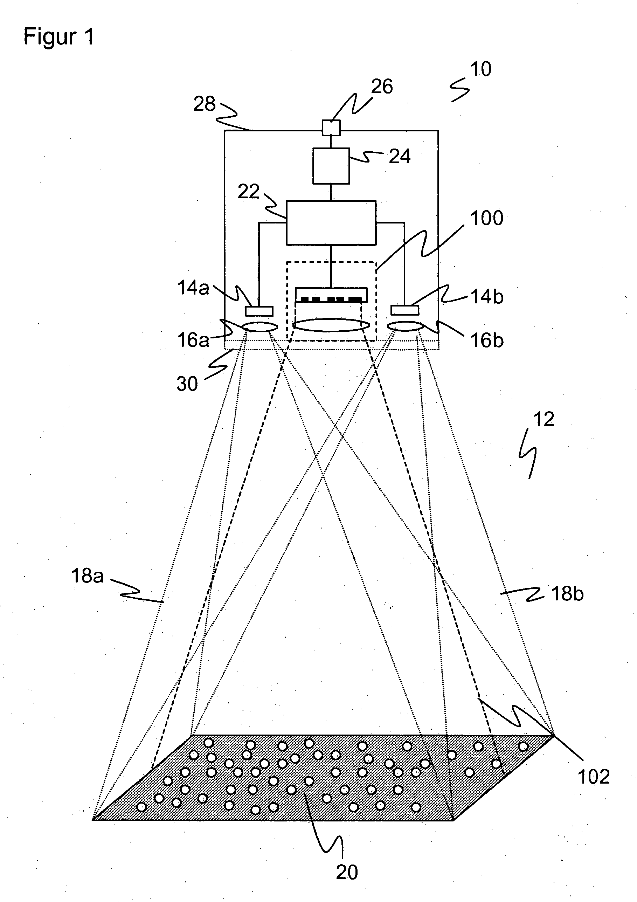

Figur 1 zeigt in einer schematischen dreidimensionalen Darstellung den allgemeinen Aufbau einer erfindungsgemäßen 3D-Kamera 10 nach dem Stereoskopieprinzip, die zur Überwachung eines Raum- oder Überwachungsbereichs 12 eingesetzt ist. Die Erfindung wird an diesem Beispiel einer stereoskopischen 3D-Kamera beschrieben, umfasst aber auch andere triangulatiönsbasierte 3D-Kameras, etwa mit nur einem Bild' sensor und Auswertung der entfernungsabhängigen Veränderungen eines Beleuchtungsmusters, wie sie beispielhaft in der Einleitung genannt sind. Mit Überwachung sind im speziellen sicherheitstechnische Anwendungen gemeint. Das kann die Absicherung einer gefährlichen Maschine sein, indem dreidimensionale Schutzbereiche in dem Überwachungsbereich 12 definiert werden, die von der 3D-Kamera auf unzulässige Eingriffe überwacht werden. Mit der 3D-Kamera sind aber auch andere Anwendungen denkbar, beispielsweise das Erfassen von bestimmten Bewegungen, die als Befehl an die 3D-Kamera 10 oder an ein daran angeschlossenes System interpretiert werden.

In der 3D-Kamera 10 sind zwei Kameramodule in einem bekannten festen Abstand zueinander montiert und nehmen jeweils Bilder des Überwachungsbereichs 12 auf. In jeder Kamera ist ein Bildsensor 14a, 14b vorgesehen, üblicherweise ein matrixförmiger Aufnahmechip, der ein rechteckiges Pixelbild aufnimmt, beispielsweise ein CCD- oder ein CMOS-Sensor. Den Bildsensoren 14a, 14b ist jeweils ein Objektiv mit einer abbildenden Optik zugeordnet, welches als Linse 16a, 16b dargestellt ist und in der Praxis als jede bekannte Abbildungsoptik realisiert sein kann. Der Sichtwinkel dieser Optiken ist in Figur 1 durch gestrichelte Linien dargestellt, die jeweils eine Sichtpyramide 18a, 18b bilden.

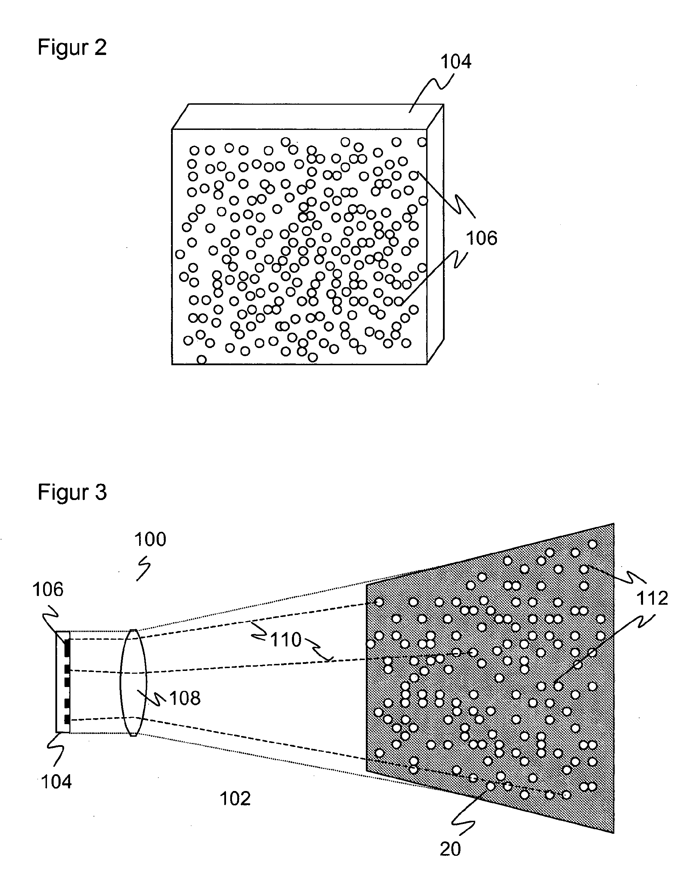

In der Mitte zwischen den beiden Bildsensoren 14a, 14b ist eine Beleuchtungseinheit 100 dargestellt, wobei diese räumliche Anordnung nur als Beispiel zu verstehen ist und die Beleuchtungseinheit ebenso asymmetrisch oder sogar außerhalb der 3D-Kamera 10 angeordnet sein kann. Die Beleuchtungseinheit 100 erzeugt in einem Beleuchtungsbereich 102 ein strukturiertes Beleuchtungsmuster 20 und wird weiter unten in verschiedenen Ausführungsformen im Zusammenhang mit den Figuren 2 bis 5 näher erläutert.

Mit den beiden Bildsensoren 14a, 14b und der Beleuchtungseinheit 100 ist eine Steuerung 22 verbunden. Mittels der Steuerung 22 wird das strukturierte Beleuchtungsmuster 20 erzeugt und bei Bedarf in seiner Struktur oder Intensität variiert, und die Steuerung 22 empfängt Bilddaten der Bildsensoren 14a, 14b. Aus diesen Bilddaten berechnet die Steuerung 22 mit Hilfe einer stereoskopischen Disparitätsschätzung dreidimensignale Bilddaten (Entfernungsbild, Tiefenkarte) des Überwachungsbereichs 12. Das strukturierte Beleuchtungsmuster 20 sorgt dabei für einen guten Kontrast und eine eindeutig zuordenbare Struktur jedes Bildelements in dem beleuchteten Überwachungsbereich 12.

Erkennt die Steuerung 22 einen unzulässigen Eingriff in einen Schutzbereich, so wird über eine Warn- oder Abschalteinrichtung 24, die wiederum in die Steuerung 22 integriert sein kann, eine Warnung ausgegeben oder die Gefahrenquelle abgesichert, beispielsweise ein Roboterarm oder eine sonstige Maschine gestoppt. Sicherheitsrelevante Signale, also vor allem das Abschaltsignal, werden über einen Sicherheitsausgang 26 ausgegeben (OSSD, Output Signal Switching Device). In nichtsicherheitstechnischen Anwendungen kann auf diese Funktionalität auch verzichtet werden. Ebenso ist denkbar, dass die dreidimensionalen Bilddaten lediglich als solche ausgegeben und weitere Auswertungen extern vorgenommen werden.

Um für sicherheitstechnische Anwendungen geeignet zu sein, ist die 3D-Kamera 10 fehlersicher ausgelegt. Dies bedeutet unter anderem, dass die 3D-Kamera 10 sich selber in Zyklen unterhalb der geforderten Ansprechzeit testen kann, insbesondere auch Defekte der Beleuchtungseinheit 100 erkennt und somit sicherstellt, dass das Beleuchtungsmuster 20 in einer erwarteten Mindestintensität verfügbar ist, und dass der Sicherheitsausgang 26 sowie die Warn- oder Abschalteinrichtung 24 sicher, beispielsweise zweikanalig ausgelegt sind. Ebenso ist auch die Steuerung 22 selbstsicher, wertet also zweikanalig aus oder verwendet Algorithmen, die sich selbst prüfen können. Derartige Vorschriften sind für allgemeine berührungslos wirkende Schutzeinrichtungen beispielsweise in der EN 61496-1 bzw. der EN 13849-1 normiert. Eine entsprechende Norm für Sicherheitskameras befindet sich in der Vorbereitung.

Die Sicherheitskamera 10 wird von einem Gehäuse 28 umgeben und geschützt. Durch eine Frontscheibe 30 kann Licht in und aus dem Überwachungsbereich 12 hindurchtreten. Die Frontscheibe 30 hat Filtereigenschaften, welche auf die Sendefrequenz der Beleuchtungseinheit 100 abgestimmt ist. Selbst mit lichtstarken Beleuchtungseinheiten 100 kann nämlich bei ungünstigen Bedingungen, wie sehr hellen Umgebungen, großen Überwachungsvolumina oder großen Abständen von 5 Metern und mehr, das Nutzsignal im Rauschen des Gesamtspektrums nicht hinreichend detektiert werden. Mit einer Beleuchtungseinheit 100, die nur Licht in einem oder mehreren schmalen sichtbaren, ultravioletten oder infraroten Bändern aussendet, und einem darauf abgestimmten Filter 30 kann das Signal/Rauschverhältnis ganz erheblich verbessert werden, weil Umgebungslicht außerhalb dieser Bänder keine Rolle mehr spielt. Der optische Filter 30 kann auch anders realisiert sein, etwa in den Objektiven der Kameramodule.

Figur 2 zeigt eine schematische Draufsicht auf eine Lichtquelle für die Beleuchtungseinheit 100. Bei der Lichtquelle handelt es sich um ein Halbleiterarray 104, insbesondere ein VCSEL-Array mit einer Vielzahl von Einzelemitterelementen 106. Das Array hat eine Kantenlänge von einigen Millimetern, kann aber auch größer ausgebildet werden. Dies kann nicht nur durch einen größeren Chip, sondern auch mehrere nebeneinander angeordnete Chips erreicht werden.

Jedes Einzelemitterelement 106 wird von einer punktförmigen Abstrahlfläche gebildet, die einen Durchmesser von etwa 10um aufweist. Dieser Durchmesser ist rein beispielhaft und skalierbar, indem die gewünschte Größe der entstehenden Musterelemente durch entsprechende Abbildung der durch den Durchmesser vorgegebenen Größe der Einzelemitterelemente 106 erzeugt wird. Das Halbleiterarray 104 umfasst eine große Anzahl von einigen tausend Einzelemitterelementen 106. Je nach gewünschter Struktur des zu erzeugenden Beleuchtungsmusters 20 kann diese Anzahl aber auch größer als zehntausend, hunderttausend oder sogar noch größer sein.

Eine Besonderheit des Halbleiterarrays 104 liegt darin, dass die Einzelemitterelemente 106 keine regelmäßige Matrixanordnung bilden, sondern unregelmäßig verteilt sind. Die Abstände der Einzelemitterelemente 106 untereinander variieren demnach in einem Muster, das zur Vermeidung von Scheinkorrelationen zumindest lokal innerhalb der erforderlichen Korrelationslängen nicht durch Translationen in den maßgeblichen Richtungen, beispielsweise parallel zum Horizont, in sich selbst überführt werden kann. Um diese Anordnung im Herstellungsprozess zu erhalten, wird beispielsweise in dem Prozessschritt, in dem die punktförmigen Abstrahlflächen erzeugt werden, eine unregelmäßige statt einer regelmäßigen Maske eingesetzt. Die Struktur dieser Maske wird beispielsweise durch Simulationen oder Berechnungen vorgegeben, um die 3D-Kamera optimal zu unterstützen.

Die Einzelemitterelemente 106 können mit gleicher optischer Ausgangsleistung betrieben werden. Dann sind die einzelnen Musterelemente untereinander gleich hell. In einer vorteilhaften Weiterbildung wird davon aber gezielt abgewichen, beispielsweise indem die Einzelemitterelemente 106 mit unterschiedlichen Strömen angesteuert werden. Dies lässt sich erreichen, indem die Einzelemitterelemente 106 einzeln ansteuerbar sind. Eine andere Möglichkeit, bei der mit einer einheitlichen Spannung gearbeitet und auf eine individuelle Ansteuerung verzichtet werden kann, sind unterschiedliche Designs der Einzelemitterelemente 106, etwa unterschiedliche Widerstände in den Zuleitungen durch unterschiedliche Leitungsdicken oder dergleichen. Damit werden Teilbereiche des Beleuchtungsmusters 20 gezielt aufgehellt oder abgedunkelt. Eine Anwendung ist eine Randbereichsüberhöhung mit besonders hellen Rändern des Beleuchtungsmusters 20, um einen entsprechenden Randbereichsabfall der Bildsensoren 14a-b beziehungsweise der Optiken 16a-b zu kompensieren. So werden besonders homogen ausgeleuchtete Bilder aufgenommen. Dazu werden die Einzelemitterelemente 106 in einem Außenbereich des Halbleiterarrays 104 stärker bestromt als in dessen Innerem und senden somit mehr Licht aus.

Eine andere Möglichkeit, solche Effekte unterschiedlicher Helligkeit zu erreichen, besteht darin, die Flächengrößen der Einzelemitterelemente 106 zu variieren, beispielsweise indem wiederum in dem entsprechenden Prozessschritt eine angepasste Maske verwendet wird. Eine nochmals andere Möglichkeit besteht darin, in der Punktdichte beziehungsweise der Packungsdichte der Einzelemitterelemente 106 gezielt von einer homogenen Verteilung abzuweichen, etwa im Randbereich des Halbleiterarrays 104 mehr Einzelemitterelemente 106 vorzusehen als in dessen Innerem. Unterschiedliche Ausgangsleistungen, Flächengrößen und Packungsdichten lassen sich auch miteinander kombinieren.

Figur 3 zeigt in einer schematischen Ansicht der Beleuchtungseinheit 100, wie mit Hilfe des Halbleiterarrays 104 das Beleuchtungsmuster 20 erzeugt wird. Dazu wird dem Halbleiterarray 104 ein Abbildungsobjektiv 106 nachgeordnet, welches das von der unregelmäßigen Anordnung der Einzelemitterelemente 106 auf dem Halbleiterarray 104 gebildete Muster aus dem Nahfeld bei dem Halbleiterarray 104 als Beleuchtungsmuster 20 in den Beleuchtungsbereich 102 und damit die zu überwachende Szenerie projiziert. Das Abbildungsobjektiv 106 ist im einfachsten Fall eine Sammellinse, kann aber in an sich bekannter Weise auch andere oder mehrere optische Elemente aufweisen.

Das Beleuchtungsmuster 20 entsteht demnach durch direkte Abbildung der auf dem Halbleiterarray 104 unregelmäßig angeordneten Einzelemitterelemente 106. Die in einer Ebene an dem Halbleiterarray 104 an den unregelmäßig verteilten Orten befindlichen Einzelemitterelemente 106 erzeugen über jeweils einen Einzellichtstrahl 110 ein Musterelement 112 oder einen Lichtpunkt des Beleuchtungsmusters 20.

In ihrer Gesamtheit bilden die Musterelemente 112 das unregelmäßige Beleuchtungsmuster 20, das auch einer strukturlosen Szenerie die erforderliche Struktur aufprägt und die Erkennung von Scheinkorrespondenzen durch einen Stereoalgorithmus verhindert. Alternativ zu einem Stereoalgorithmus kann die Veränderung der erwarteten Struktur des Beleuchtungsmusters 20 durch Objekte in der Szenerie ausgewertet werden.

Das erzeugte Beleuchtungsmuster 20 entspricht in seiner Struktur unmittelbar der Anordnung der Einzelemitterelemente 106, wobei durch die Projektion eine Skalierung erfolgt. Dabei ist die Darstellung des Beleuchtungsmusters 20 in den Figuren rein schematisch zu verstehen. In der Praxis wird die tatsächliche Anzahl von Musterelemengen 112 entsprechend der Anzahl Einzelemitterelemente 106 wesentlich höher sein und auch andere Füllgrade erzielen, wobei ein Füllgrad von etwa 10-20% häufig für eine zuverlässige Aufnahme einer dichten Tiefenkarte ausreicht.

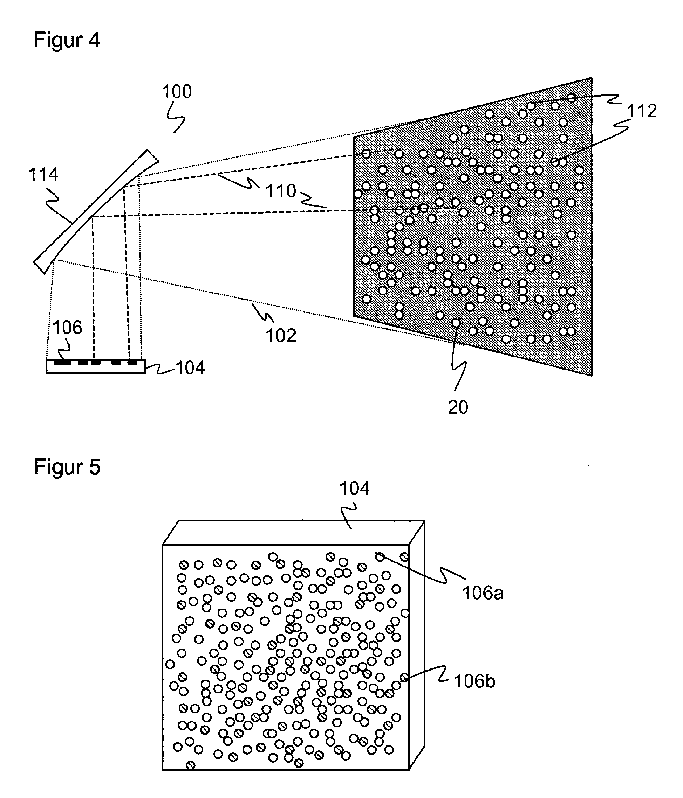

Figur 4 zeigt einen alternativen Aufbau der Beleuchtungseinheit 100. Anstelle eines refraktiven Abbildungsobjektivs 108 wird hier eine reflexive Abbildungsoptik 114 eingesetzt. Dabei kann es sich um einen konkaven Spiegel handeln. Wie bei der refraktiven Abbildungsoptik 108 sind auch für die reflexive Abbildungsoptik 114 andere, an sich bekannte Aufbauten denkbar.

Figur 5 zeigt eine Draufsicht auf eine alternative Ausgestaltung des Halbleiterarrays 104. Dabei sind die Einzelemitterelemente 106 in zwei durch unterschiedliche Schraffur dargestellte Gruppen 106 a-b aufgeteilt. Die Gruppen 106a-b können dabei einzeln angesteuert werden, so dass ihre jeweiligen Einzelemitterelemente 106 wahlweise aktiv oder inaktiv sind oder unterschiedlich hell leuchten. Damit können mit demselben Halbleiterarray 104 unterschiedliche Beleuchtungsmuster 20 erzeugt werden, um sich an Anwendungen, 3D-Kameras oder Szenerien anzupassen. Wird eine größere Anzahl solcher Gruppen gebildet, so bietet die Kombinatorik gleichzeitig aktiver Gruppen vielfältige Variationsmöglichkeiten. Im Grenzfall sind die Einzelemitterelemente 106 sogar einzeln ansteuerbar. Die allgemeine Packungsdichte wird in einer Ausführungsform gemäß Figur 5 im allgemeinen etwas höher gewählt als ohne solche Gruppen, damit auch dann, wenn einige Gruppen nicht aktiv sind, das Beleuchtuhgsmüster 20 noch den erforderlichen Füllgrad aufweist.

Während also bei den im Zusammenhang mit Figur 2 beschriebenen Ausführungsformen eher eine einmalige Anpassung des Beleuchtungsmusters 20 per Design im Vordergrund steht, kann durch gruppenweise oder sogar individuelle Ansteuerung der Einzelemitterelemente 106 die Anpassung ganz flexibel in einer Konfigurationsphase oder sogar noch während des Betriebs erfolgen.

Weiterhin ist denkbar, das Halbleiterarray 104 gegenüber der Abbildungsoptik 108, 114 verschieblich anzuordnen. Durch entsprechende Justage wird dann ein Teilbereich des Halbleiterarrays 104 ausgewählt, der als Beleuchtungsmuster 20 projiziert wird. Auch auf diese Weise kann eine Anpassung erfolgen.

In einer nicht dargestellten weiteren Ausführungsform wird dem Halbleiterarray 104 ein Mikrolinsenarray vorgeordnet. Mikrolinsen eignen sich prinzipiell, um die Struktur des Beleuchtungsmusters 20 zu manipulieren, indem die Position und Form einzelner Musterelemente 112 beeinflusst wird. Erfindungsgemäß liegt eine besonders bevorzugte Funktion eines Mikrolinsenarrays darin, die einzelnen Musterelemente 112 zu fokussieren, um eine Divergenz der Einzelemitterelemente 106 auszugleichen. Damit bleibt das durch die Anordnung der Einzelemitterelemente 106 auf dem Halbleiterarray 104 vorgegebene Muster auch als Beleuchtungsmuster 20 erhalten. Die Mikrolinsen auf dem Mikrolinsenarray sind dafür vorzugsweise in gleicher Weise angeordnet wie die Einzelemitterelemente 106. Jedem Einzelemitterelement 106 ist dann eine Mikrolinse direkt vorgeordnet, um gezielt die gewünschte Fokussierung des jeweiligen Musterelements 112 zu bewirken.

## Patentansprüche

1. 3D-Kamera (10) mit mindestens einem Bildsensor (14a-b) und mit einer Beleuchtungseinheit (100), die eine Lichtquelle mit einem Halbleiterarray (104) mit einer Vielzahl von Einzelemitterelementen aufweist und die für die Erzeugung eines unregelmäßigen Beleuchtungsmusters (20) in einem Überwachungsbereich (12) der 3D-Kamera (10) ausgebildet ist,
**dadurch gekennzeichnet,**
**dass** jeweils ein Einzelemitterelement (106) ein Musterelement (112) des unregelmäßigen Beleuchtungsmusters (20) erzeugt und dass die Einzelemitterelemente (106) unregelmäßig angeordnet sind, so dass die unregelmäßige Struktur des Beleuchtungsmusters (20) durch die unregelmäßige Anordnung der Einzelemitterelemente (106) erreicht wird.

2. 3D-Kamera (10) nach Anspruch 1,
wobei das Halbleiterarray (104) ein VCSEL-Array ist.

3. 3D-Kamera (10) nach Anspruch 1 oder 2,
wobei das Halbleiterarray (104) eine große Anzahl von mindestens tausend, zehntausend oder hunderttausend Einzelemitterelementen (106) aufweist.

4. 3D-Kamera (10) nach einem der vorhergehenden Ansprüche,
wobei jedes Einzelemitterelement (106) eine punktförmige Abstrahlfläche aufweist, und wobei das von dem Einzelemitterelement (106) erzeugte Musterelement (112) die Form der Abstrahlfläche aufweist.

5. 3D-Kamera (10) nach Anspruch 4,
wobei die punktförmigen Abstrahlflächen untereinander unterschiedliche Formen und/oder Größen aufweisen.

6. 3D-Kamera (10) nach einem der vorhergehenden Ansprüche,
wobei Einzelemitterelemente (106) mindestens zwei Gruppen (106a-b) bilden, und wobei eine Gruppe (106a-b) von Einzelemitterelementen (106) aktivierbar ist, ohne die übrigen Gruppen (106a-b) von Einzelemitterelementen (106) zu aktivieren.

7. 3D-Kamera (10) nach einem der vorhergehenden Ansprüche,
wobei die Einzelemitterelemente (106) mit untereinander unterschiedlichen Strömen ansteuerbar sind, insbesondere Einzelemitterelemente (106) in einem Außenbereich des Halbleiterarrays (104) mit höheren Strömen ansteuerbar sind als Einzelemitterelemente (106) in einem Innenbereich des Halbleiterarrays (104).

8. 3D-Kamera (10) nach einem der vorhergehenden Ansprüche,
wobei die Dichte der Einzelemitterelemente (106) auf dem Halbleiterarray (104) unterschiedlich ist, insbesondere in einem Außenbereich des Halbleiterarrays (104) mehr Einzelemitterelemente (106) vorgesehen sind als in einem Innenbereich des Halbleiterarrays (104).

9. 3D-Kamera (10) nach einem der vorhergehenden Ansprüche,
wobei die Anordnung der Musterelemente (112) in dem Beleuchtungsmuster (20) der Anordnung der Einzelemitterelemente (106) auf dem Halbleiterarray (104) entspricht.

10. 3D-Kamera (10) nach einem der vorhergehenden Ansprüche,
wobei die Beleuchtungseinheit (100) ein Abbildungsobjektiv (108, 114) aufweist, um das Beleuchtungsmuster (20) aus dem Nahfeld bei dem Halbleiterarray (104) in den Überwachungsbereich (12) abzubilden.

11. 3D-Kamera (10) nach einem der vorhergehenden Ansprüche,
wobei Abbildungsobjektiv (108, 114) und Halbleiterarray (104) zueinander verschieblich angeordnet sind, um unterschiedliche Teilmengen von Einzelemitterelementen (106) abzubilden.

12. 3D-Kamera (10) nach einem der vorhergehenden Ansprüche,
wobei dem Halbleiterarray (104) ein Mikrolinsenarray vorgeordnet ist, wobei insbesondere die Mikrolinsen auf dem Mikrolinsenarray die gleiche unregelmäβige Anordnung bilden wie die Einzelemitterelemente (106) auf dem Halbleiterarray (104)..

13. 3D-Kamera (10) nach einem der vorhergehenden Ansprüche,
die als Stereokamera ausgebildet ist und eine Auswertungseinheit (22) aufweist, welche für die Anwendung eines Stereoalgorithmus ausgebildet ist, in dem zur Erzeugung eines dreidimensionalen Entfernungsbildes einander zugehörige Teilbereiche der von den beiden Kameras (14a-b, 16a-b) der Stereokamera aufgenommenen Bilder des von dem Beleuchtungsmuster (20) ausgeleuchteten Überwachungsbereichs (12) erkannt und deren Entfernung anhand der Disparität berechnet wird.

14. 3D-Kamera (10) nach einem der vorhergehenden Ansprüche,
die als Sicherheitskamera ausgebildet ist, wobei die Auswertungseinheit (22) unzulässige Eingriffe in den Überwachungsbereich (12) erkennen und daraufhin ein Abschaltsignal erzeugen kann, und wobei ein Sicherheitsausgang (26) vorgesehen ist, um darüber ein Abschaltsignal an eine überwachte Maschine auszugeben.

15. Verfahren zur dreidimensionalen Erfassung eines Überwachungsbereichs (12), bei dem eine Beleuchtungseinheit (100) ein unregelmäßiges Beleuchtungsmuster (20) in dem Überwachungsbereich (12) erzeugt, wobei eine 3D-Kamera (10) Bilder des derart ausgeleuchteten Überwachungsbereichs (12) aufnimmt, wobei von einem Halbleiterarray (104) mit einer Vielzahl von Einzelemitterelementen (106) eine entsprechende Vielzahl von Einzellichtstrahlen (110) ausgesandt wird,
**dadurch gekennzeichnet,**
**dass** die Einzelemitterelemente (106) auf dem Halbleiterarray (104) unregelmäßig angeordnet sind und das Bündel der Einzellichtstrahlen (110) aufgrund der unregelmäßigen Anordnung zu der unregelmäßigen Struktur des Beleuchtungsmusters führt (20), wobei jeweils ein Einzelemitterelement (106) über seinen Einzellichtstrahl (110) ein punktförmiges Musterelement (112) des Beleuchtungsmusters (20) erzeugt.

## Claims

1. A 3D-camera (10) having at least one image sensor (14a-b) and at least one illumination unit (100) which comprises a light source with a semiconductor array (104) having a plurality of individual emitter elements (106) and which is configured for generating an irregular illumination pattern (20) in an illumination area (12) of the 3D-camera (10),
**characterized in that** a respective individual emitter element (106) generates a pattern element (112) of the irregular illumination pattern (20) and **in that** the individual emitter elements (106) have an irregular arrangement so that the irregular structure of the illumination pattern (20) is obtained by the irregular arrangement of the individual light emitters (106).

2. The 3D-camera (10) according to claim 1,
wherein the semiconductor array (104) is a VCSEL array.

3. The 3D-camera (10) according to claim 1 or 2,
wherein the semiconductor array (104) comprises a large number of at least a thousand, ten thousand, or a hundred thousand individual emitter elements (106).

4. The 3D-camera (10) according to any of the preceding claims,
wherein each individual emitter element (106) comprises a point-like emitter surface, and wherein the pattern element (112) generated by the individual emitter element (106) comprises the shape of the emitter surface.

5. The 3D-camera (10) according to claim 4,
wherein the point-like emitter surfaces have mutually different shapes and/or sizes.

6. The 3D-camera (10) according to any of the preceding claims,
wherein the individual emitter elements (106) form at least two groups (106a-b), and wherein a group (106a-b) of individual emitter elements (106) can be activated without activating the remaining groups (106a-b) of individual emitter elements (106).

7. The 3D-camera (10) according to any of the preceding claims,
wherein the individual emitter elements (106) are controllable with mutually different currents, in particular individual emitter elements (106) in an outer region of the semiconductor array (104) are controllable with higher currents than individual emitter elements (106) in an inner region of the semiconductor array (104).

8. The 3D-camera (10) according to any of the preceding claims,
wherein the density of the individual emitter elements (106) on the semiconductor array (104) varies, in particular more individual emitter elements (106) are provided in an outer region of the semiconductor array (104) than in an inner region of the semiconductor array (104).

9. The 3D-camera (10) according to any of the preceding claims,
wherein the arrangement of the pattern elements (112) in the illumination pattern (20) corresponds to the arrangement of the individual emitter elements (106) on the semiconductor array (104).

10. The 3D-camera (10) according to any of the preceding claims,
wherein the illumination unit (100) comprises an imaging objective (108, 114) to image the illumination pattern (20) from the near field at the semiconductor array (104) into the monitoring area (12).

11. The 3D-camera (10) according to any of the preceding claims,
wherein imaging objective (108, 114) and semiconductor array (104) are arranged mutually movable to image different subsets of individual emitter elements (106).

12. The 3D-camera (10) according to any of the preceding claims,
wherein a microlens array is arranged in front of the semiconductor array (104), wherein in particular the microlenses have the same irregular arrangement on the microlens array as the individual emitter elements (106) on the semiconductor array (104).

13. The 3D-camera (10) according to any of the preceding claims,
which is made as a stereo camera and comprises an evaluation unit (22) configured for the application of a stereo algorithm which, for generating a three-dimensional distance image, detects partial regions corresponding to one another in the two images of the monitoring area (12) illuminated by the illumination pattern (20) and captured by the two cameras (14a-b, 16a-b) of the stereo camera, and calculates the distances from their disparity.

14. The 3D-camera (10) according to any of the preceding claims,
which is made as a safety camera, wherein the evaluation unit (22) is configured to detect forbidden intrusions into the monitoring area (12) and to thereupon generate a shutdown signal, and wherein a safety output (26) is provided to output a shutdown signal to a monitored machine.

15. A method for the three-dimensional monitoring of a monitoring area (12), wherein an illumination unit (100) generates an irregular illumination pattern (20) in the monitoring area (12), wherein a 3D-camera (10) captures images of the illuminated monitoring area (12), wherein a semiconductor array (104) having a plurality of individual emitter elements (106) emits a corresponding plurality of individual light beams (110),
**characterized in that** the individual emitter elements (106) are arranged irregularly on the semiconductor array (104) and the bundle of individual light beams (110) leads to the irregular structure of the illumination pattern (20) due to the irregular arrangement, wherein a respective individual emitter element (106) generates a point-like pattern element (112) of the illumination pattern (20) via its individual light beam (110).

## Revendications

1. Caméra 3D (10) comprenant au moins un capteur d'images (14a-b) et comprenant une unité d'éclairage (100), qui inclut une source de lumière avec un réseau semi-conducteur (104) doté d'une pluralité d'éléments émetteurs individuels, et qui est réalisée pour engendrer un motif d'éclairage irrégulier (20) dans une zone de surveillance (12) de la caméra 3D (10),
**caractérisée en ce que**
un élément émetteur individuel (106) engendre respectivement un élément de motif (112) du motif d'éclairage irrégulier (20), et **en ce que** les éléments émetteurs individuels (106) sont agencés irrégulièrement de telle façon que la structure irrégulière du motif d'éclairage (20) est atteinte grâce à l'agencement irrégulier des éléments émetteurs individuels (106).

2. Caméra 3D (10) selon la revendication 1,
dans laquelle le réseau semi-conducteur (104) est un réseau VCSEL.

3. Caméra 3D (10) selon la revendication 1 ou 2,
dans laquelle le réseau semi-conducteur (104) comprend un grand nombre, d'au moins 1000, 10 000 ou 100 000 éléments émetteurs individuels (106).

4. Caméra 3D (10) selon l'une des revendications précédentes,
dans laquelle chaque élément émetteur individuel (106) comporte une surface de rayonnement ponctuelle, et dans laquelle l'élément de motif engendré par l'élément émetteur individuel (106) présente la forme de la surface de rayonnement.

5. Caméra 3D (10) selon la revendication 4,
dans laquelle les surfaces de rayonnement ponctuelles ont des formes et/ou des tailles différentes les unes des autres.

6. Caméra 3D (10) selon l'une des revendications précédentes,
dans laquelle des éléments émetteurs individuels (106) forment au moins deux groupes (106a-b), et dans laquelle un groupe (106a-b) d'éléments émetteurs individuels (106) est susceptible d'être activé sans activer les autres groupes (106a-b) d'éléments émetteurs individuels (106).

7. Caméra 3D (10) selon l'une des revendications précédentes,
dans laquelle les éléments émetteurs individuels (106) sont susceptibles d'être pilotés avec des courants différents les uns des autres, et en particulier en ce que des éléments émetteurs individuels (106) dans une zone extérieure du réseau semi-conducteur (104) sont susceptibles d'être pilotés avec des courants plus élevés que des éléments émetteurs individuels (106) dans une zone intérieure du réseau semi-conducteur (104).

8. Caméra 3D (10) selon l'une des revendications précédentes,
dans laquelle la densité des éléments émetteurs individuels (106) sur le réseau semi-conducteur (104) est différente, en particulier en ce qu'il est prévu dans une zone extérieure du réseau semi-conducteur (104) plus d'éléments émetteurs individuels (106) que dans une zone intérieure du réseau semi-conducteur (104).

9. Caméra 3D (10) selon l'une des revendications précédentes,
dans laquelle l'agencement des éléments de motif (112) dans le motif d'éclairage (20) correspond à l'agencement des éléments émetteurs individuels (106) sur le réseau semi-conducteur (104).

10. Caméra 3D (10) selon l'une des revendications précédentes,
dans laquelle l'unité d'éclairage (100) comprend un objectif d'imagerie (108, 114), afin de produire une image du motif d'éclairage (20) provenant du champ proche dans le réseau semi-conducteur (104) dans la zone de surveillance (12).

11. Caméra 3D (10) selon l'une des revendications précédentes,
dans laquelle l'objectif d'imagerie (108, 114) et le réseau semi-conducteur (104) sont agencés déplaçables l'un par rapport à l'autre, afin de réaliser l'image de groupes partiels différents d'éléments émetteurs individuels (106).

12. Caméra 3D (10) selon l'une des revendications précédentes,
dans laquelle un réseau de microlentilles est agencé avant le réseau semi-conducteur (104), dans laquelle en particulier les microlentilles forment sur le réseau de microlentilles le même agencement irrégulier que les éléments émetteurs individuels (106) sur le réseau semi-conducteur (104).

13. Caméra 3D (10) selon l'une des revendications précédentes,
qui est réalisée sous forme de caméra stéréoscopique et comprend une unité d'évaluation (22), qui est réalisée pour l'application d'un algorithme stéréoscopique, dans laquelle, pour engendrer une image d'éloignement tridimensionnel, des zones partielles mutuellement associées, des images enregistrées par les deux caméras (14a-b, 16a-b) de la caméra stéréoscopique, de la zone de surveillance (12) éclairée par le motif d'éclairage (20) sont reconnues et leur éloignement est calculé au moyen de la disparité.

14. Caméra 3D (10) selon l'une des revendications précédentes,
réalisée sous forme de caméra de sécurité, dans laquelle l'unité d'évaluation (22) peut reconnaître des interventions inadmissibles dans la zone de surveillance (12) et engendrer suite à cela un signal de coupure, et dans laquelle il est prévu une sortie de sécurité (26) pour délivrer via celle-ci un signal de coupure à une machine surveillée.

15. Procédé pour la détection tridimensionnelle d'une zone de surveillance (12), dans lequel une unité d'éclairage (100) engendre un motif d'éclairage irrégulier (20) dans la zone de surveillance (12), dans lequel une caméra 3D (10) enregistre des images de la zone de surveillance (12) ainsi éclairée, dans lequel une pluralité de rayons de lumière individuels (110) sont émis en correspondance d'un réseau semi-conducteur (104) avec une pluralité d'éléments émetteurs individuels (106),
**caractérisé en ce que**
les éléments émetteurs individuels (106) sont agencés irrégulièrement sur le réseau semi-conducteur (104), et le faisceau des rayons de lumière individuels (110) mène, en raison de l'agencement irrégulier, à la structure irrégulière du motif d'éclairage (20), et dans lequel un élément émetteur individuel (106) engendre respectivement, via son rayon de lumière individuel (110), un élément de motif ponctuel (112) du motif d'éclairage (20).
